(19) Europäisches Patentamt / European Patent Office / Office européen des brevets

(11) **EP 4 459 370 A1**

(12) **EUROPEAN PATENT APPLICATION**

(43) Date of publication:
**06.11.2024 Bulletin 2024/45**

(21) Application number: **23171087.2**

(22) Date of filing: **02.05.2023**

(51) International Patent Classification (IPC):
**G02F 1/21** (2006.01)   **G02B 26/08** (2006.01)
**G02B 6/12** (2006.01)

(52) Cooperative Patent Classification (CPC):
**G02F 1/21; G02B 26/0833;** G02B 2006/12104;
G06N 10/40; H01S 2301/02

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Alpine Quantum Technologies GmbH 6020 Innsbruck (AT)**

(72) Inventors:
• **CERCHIARI, Giovanni**
**6080 Innsbruck (AT)**
• **PANZL, Lorenz**
**6020 Innsbruck (AT)**
• **WEISER, Yannick**
**6020 Innsbruck (AT)**
• **ERHARD, Alexander**
**6020 Innsbruck (AT)**

(74) Representative: **Grünecker Patent- und Rechtsanwälte PartG mbB Leopoldstraße 4 80802 München (DE)**

Remarks:
Amended claims in accordance with Rule 137(2) EPC.

(54) **SUPPRESSION OF SPONTANEOUS EMISSIONS**

(57)    Some embodiments in the present disclosure relate to an apparatus and methods for suppressing spontaneous emissions of two or more quantum emitters. The two or more quantum emitters are located in a plane. A reflector is located along an axis perpendicular to the plane. The reflector reflects an emission of a quantum emitter out of the two or more quantum emitters according to a boundary condition, wherein the boundary condition includes obtaining destructive interference of the reflected emissions with the emissions of the two or more quantum emitters.

**FIG. 3**

## Description

TECHNICAL FIELD

Embodiments of the present invention relate to the field of controlling spontaneous emission of quantum emitters.

BACKGROUND

Many technical applications (e.g. quantum computing, quantum simulations, atomic and molecular experiments, spectroscopy, atomic clocks, etc.) require excited states of quantum entities that are used to efficiently encode quantum information.

For example, the quantum entity to be excited may be an ion trapped in an ion trap. A setup of such ion trap may include a plurality of electrodes within a vacuum chamber.

For example, in the field of quantum computing, such trapped ions are used as qubit registers. To perform quantum operations by implementing quantum gates on said ion register, one or more trapped ions are excited and/or entangled using laser beams directed to the trapped ions.

SUMMARY

It may be desirable to control the spontaneous emissions of quantum entities by suppressing and/or guiding said emissions.

In some embodiments, this is achieved by applying a boundary condition including obtaining destructive interference of the emission and a reflected emission. In some embodiments, said boundary condition is applied except for specific directions.

The invention is defined by the scope of independent claims. Some of the advantageous embodiments are provided in the dependent claims.

According to an embodiment, an apparatus for suppressing spontaneous emissions of two or more quantum emitters is provided. The apparatus comprises two or more quantum emitters, which are located in a plane; and a reflector located along an axis perpendicular to the plane. The reflector is adapted to reflect an emission of a quantum emitter out of the two or more quantum emitters according to a boundary condition, wherein the boundary condition includes obtaining destructive interference of the reflected emissions with the emissions of the two or more quantum emitters.

In an exemplary implementation, the reflector is adapted to reflect emissions of the at least two quantum emitters out of the two or more emitters simultaneously.

For example, the apparatus further includes a controller configured to control one or more of a position of the reflector and/or a position of an emitter out of the two or more emitters, and a reflection property of the reflector including a phase of the reflected emission based on the boundary condition.

In an exemplary implementation, the reflector includes one or more of a mirror and a spatial light modulator, SLM.

For example, the SLM is one of a phase spatial light modulator or a micro mirror array, and the controller is configured to control, for each pixel of the SLM, a phase of a reflected emission based on the boundary condition.

In an exemplary implementation, the apparatus further includes means for guiding the emission of the quantum emitter onto the reflector, wherein the means for guiding the emission are located along the axis perpendicular to the plane.

For example, the apparatus further includes a lens as means for guiding the emission of the quantum emitter, the lens being arranged between the two or more quantum emitters and the reflector, wherein the two or more quantum emitters are located in a focal plane of said lens.

According to an embodiment, a method for suppressing spontaneous emissions of two or more quantum emitters is provided. The method comprises reflecting, by a reflector an emission of an quantum emitter out of the two or more quantum emitters according to a boundary condition, wherein the two or more emitters are located in a plane. The reflector is located along an axis perpendicular to the plane, and the boundary condition includes obtaining destructive interference of the reflected emissions with the emissions of the two or more quantum emitters.

These and other features and characteristics of the presently disclosed subject matter, as well as the methods of operation and functions of the related elements of structures and the combination of parts and economies of manufacture, will become more apparent upon consideration of the following description and the appended claims with reference to the accompanying drawings, all of which form a part of this specification. It is to be expressly understood, however, that the drawings are for the purpose of illustration and description only and are not intended as a definition of the limits of the disclosed subject matter.

BRIEF DESCRIPTION OF DRAWINGS

An understanding of the nature and advantages of various embodiments may be realized by reference to the following figures.

Fig. 1    is an exemplary block diagram illustrating an apparatus for controlling spontaneous emissions of a quantum emitter;

Fig. 2    is another exemplary block diagram illustrating an apparatus for controlling spontaneous emissions of a quantum emitter;

Fig. 3    illustrate an angled view of an apparatus for suppressing spontaneous emissions of two or more quantum emitters including a spatial light modulator and a lens;

Fig. 4    illustrate a side view of an apparatus for suppressing spontaneous emissions of two or more quantum emitters including a spatial light modulator and a lens;

Fig. 5    is a schematic diagram illustrating an apparatus for suppressing emissions of two or more quantum emitters including a hemispherical reflector in an angled view;

Fig. 6    is a schematic diagram illustrating an apparatus for suppressing emissions of two or more quantum emitters including a hemispherical reflector in a side view;

Figs. 7A-C    exemplarily illustrate an apparatus including a hemispherical mirror for constraining a spatial emission to a specific direction;

Figs. 8A-C    exemplarily illustrate an apparatus including a parabolic mirror and a flat reflector for constraining a spatial emission to a specific direction;

Fig. 9    is an exemplary flowchart for suppressing a spontaneous emission;

Fig. 10    is an exemplary flowchart for constraining a spontaneous emission;

Fig. 11    is a block diagram illustrating an exemplary controller included in the apparatus for exciting a trapped ion.

DETAILED DESCRIPTION

In the following description, reference is made to the accompanying figures, which form part of the disclosure, and which show, by way of illustration, specific aspects of embodiments of the invention or specific aspects in which embodiments of the present invention may be used. It is understood that embodiments of the invention may be used in other aspects and comprise structural or logical changes not depicted in the figures. The following detailed description, therefore, is not to be taken in a limiting sense, and the scope of the present invention is defined by the appended claims.

It is understood that the features of the various exemplary embodiments and/or aspects described herein may be combined with each other, unless specifically noted otherwise.

For purposes of the description hereinafter, the terms "end," "upper," "lower," "right," "left," "vertical," "horizontal," "top," "bottom," "lateral," "longitudinal," and derivatives thereof shall relate to the disclosed subject matter as it is oriented in the drawing figures. However, it is to be understood that the disclosed subject matter may assume various alternative variations and step sequences, except where expressly specified to the contrary. It is also to be understood that the specific devices and processes illustrated in the attached drawings, and described in the following specification, are simply exemplary embodiments or aspects of the disclosed subject matter. Hence, specific dimensions and other physical characteristics related to the embodiments or aspects disclosed herein are not to be considered as limiting unless otherwise indicated.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one." Furthermore, as used herein, the term "set" is intended to include one or more items (e.g., related items, unrelated items, a combination of related and unrelated items, and/or the like) and may be used interchangeably with "one or more" or "at least one." Where only one item is intended, the term "one" or similar language is used. Also, as used herein, the terms "has," "have," "having," or the like are intended to be open-ended terms. Further, the phrase "based on" is intended to mean "based at least partially on" unless explicitly stated otherwise.

*Quantum computing*

In quantum computing, quantum bits or qubits represent the basic unit of quantum information, corresponding to the quantum version of the binary digit (bit) representing a "0" and a "1" in a classical computer. A qubit is represented by a two-state (or two-level) quantum-mechanical system. In principal, such a quantum mechanical system may have more than two states. However, a suitable system is required to have at least two reliably distinguishable quantum states.

There are various physical systems, which include at least two distinguishable quantum states, for example, electron or nuclear spin states, atomic or nuclear states, nuclear magnetic resonance states, electronic states in quantum dots or the like.

For example, in a system using trapped ions (i.e. atoms or molecules with a net electrical charge), qubit states may be controlled and read out using radiation provided from one or more laser beams. Suitable elements include, for example, Beryllium Be, Magnesium Mg, Calcium Ca, Strontium Sr, Barium Ba, Radium Ra, and Ytterbium Yb.

The internal qubit levels of the ion may be chosen as a ground level and a long-lived excited level, a so-called metastable level, forming a so-called optical qubit. In optical qubits, quantum information is encoded in two electronic states connected by an electric multipole transition with frequency in the optical domain, i.e. a frequency in the range from 380 THz to 800 THz.

Alternatively, the qubit levels of the ion may be two different magnetic sublevels within the ground state of the ion with transition frequencies in the microwave to radiowave domain, forming a so-called Zeeman qubit or hyperfine qubit. Changing the state of a hyperfine qubit may involve the application of stimulated Raman transitions between the levels. Raman transitions facilitate an adiabatic transfer of an electron from a first hyperfine state to the second hyperfine state via a virtual intermediate state. Said transitions may have optical wavelengths.

Moreover, the motion of the trapped and crystallized ions becomes quantized, as the ions form a sufficiently well isolated quantum system within the ion trap. For example, the ions form a linear chain in the trap, e.g. a Paul trap, a Penning trap or the like. Ion traps are explained in detail in the section *Ion traps.* The motional modes, e.g. vibrational modes, of the entire linear chain of ions may be described by a quantum mechanical harmonic oscillator. The normal modes of a two ion crystal are the "center of mass mode" at frequency $\omega_C$, where the displacement of two ions from equilibrium is the same, and the "stretch mode" at frequency $\omega_S = 3^{1/2}\omega_C$, where the displacements are equal but in opposite directions. Two low-level states of such vibrational states may form a so-called motional qubit.

Using interaction with laser beams, trapped ions may be cooled to near their motional ground states. Such cooling of the ions may involve Doppler cooling and/or sideband cooling. Initialization of the internal qubits may be performed similarly by laser beam-induced transitions in individual ions. Qubits may be read out by applying a resonant laser beam to detect their states by fluorescence. A rapid cycling single photon transition from one of the qubit levels to a higher excited level of the ion using such a resonant laser beam results in the emission of fluorescent photons, which may be detected, if the level is populated. If the level is not populated, no fluorescent photons will be detected apart from a randomly produced dark count.

The interaction with laser beams also facilitates transitions between the two states (i.e. single-qubit operations). A pair of qubits may be entangled (i.e. two-qubit gate operations) by qubit-state dependent force using laser pulses that couple the individual qubit state to the collective motional modes of the trapped ions. Similar operation may be also applied to more than two ions. These and further examples of one or more qubit operations are provided, e.g., in H. Häffner, C.F. Roos, R. Blatt, "Quantum computing with trapped ions", Physics Reports, Volume 469, Issue 4, 2008, Pages 155-203 (https://doi.org/10.1016/j.physrep.2008.09.003) or in G. Chen, et al. Quantum Computing Devices: Principles, Designs, and Analysis. USA, CRC Press, 2019.

*Ion traps*

In the following, the term *"ion trap"* refers to any device employable to trap ions, using electric and/or magnetic field. For instance, an ion trap may be a Penning trap; a Paul trap; a three dimensional, 3D, ion trap; and/or a linear 3D trap. In this disclosure, the term ion trap refers to an assembly with a plurality of electrodes which, when driven, generate an electric field that limits (traps) the freedom of movement of ions so that they may not escape a particular (preferably small) region in the vicinity of those electrodes. It is noted that the actual ion trap device/system may include further mechanical and electrical components such as fixing means, electrical contacts, housing, power source, control circuitry, means to cool ions or the like.

Here, the term *"3D trap"* refers to all traps, which are not surface traps. Surface traps are traps where all electrodes are located in a same plane. In particular, a 3D trap may be a Penning or a Paul trap. Usually, 3D ion traps have a rotational symmetry, e.g., a discrete cylindrical symmetry or a continuous cylindrical symmetry.

Henceforth, without loss of generality, the symmetry axis of such a cylindrical symmetry is assumed to be parallel to the z-axis of a Cartesian coordinate system in which the axes are represented by three mutually orthogonal unit vectors $\hat{e}_x$, $\hat{e}_y$, and $\hat{e}_z$. In this context, the symmetry axis is also referred to as the "*axial direction*",

and $$\hat{r}(x,y) = (x\hat{e}_x + y\hat{e}_y)/\sqrt{x^2 + y^2}$$ as the "*radial direction*" (at the point $(x, y, 0) = x\hat{e}_x + y\hat{e}_y$). It is further noted that the symmetry axis may also be the axis along which multiple trapped ions typically align.

The term *"Penning trap"* refers to a trap that uses static electric and static magnetic fields to trap the ions. Usually, in a Penning trap solely static electric fields are used. In other words, usually no oscillating and/or alternating fields are used. For instance, to confine charged particles radially, a static magnetic field $\hat{B} = B_z\hat{e}_z$ in the axial direction may be used. The magnetic field $\hat{B}$ forces the charged particles to perform circular motion with angular frequency $\omega = |B_z| \cdot q/m$, where $q$ and $m$ are respectively charge and mass of the charged particles. Furthermore, in order to confine the charged particles axially, a static electric quadrupole potential $V(z, r) = V_0(z^2 - r^2/2)$ may be used.

The term *"Paul trap"* refers to a trap that uses electric fields to trap the ions. Usually, in a Paul trap, only electric fields are used to trap the ions. In particular, usually no magnetic fields are used. In general, at least one of the electric fields of a Paul trap is alternating (e.g., oscillating), and a Paul trap may use both static as well as alternating electric fields. For example, the alternating field of a Paul trap may be an alternating electric multipole field, in particular, an electric quadrupole field. Since the switching of the voltage is often at radio frequency, these traps are also called Radio Frequency (RF) traps.

A **linear 3D trap** is a particular type of a 3D trap. Usually, in a linear 3D trap, the ions are confined radially using an alternating (AC) electric field and confined axially by static (DC) electric potentials. Accordingly, a linear Paul trap is in general also a (linear) Paul trap.

*Spontaneous emissions*

The excited states of quantum entities are used to efficiently encode quantum information. Their lifetime, however, is limited by the natural process of spontaneous emission of radiation.

**Spontaneous emission** is a process in which a quantum system transits from an excited energy state to a lower energy state (e.g., its ground state) and emits a quantized amount of energy.

If the quantum system is in an excited state with energy $E_2$, it may spontaneously decay to a lower lying level (e.g., the ground state) with energy $E_1$, releasing the difference in energy between the two states as a photon. Such a photon has an angular frequency $\omega$ and an energy $\hbar\,\omega$:

$$E_2 - E_1 = \hbar\,\omega$$

where $\hbar$ is the reduced Planck constant. The phase of the photon in spontaneous emission is random as is the direction in which the photon propagates.

In addition, quantum gates that are based on laser interaction, such as light shift gates or Raman gates, are fundamentally limited by off-resonant scattering processes due to spontaneous emission. These limitations can ultimately prevent the construction of high-performance storage devices for quantum information and limit the fidelity of quantum operations.

*Suppression of spontaneous emissions*

As indicated above, for example, for quantum (gate) operations, an enhancing of the lifetime of an excited state of a quantum entity is desired. Such an enhancement of lifetime may improve the storage time for information and/or may lower the error limit for qubit operations, e.g., quantum gates, which are explained above in the section *Quantum Computing*. A spontaneous emission occurs at a certain rate (photons/second) and it is desirable to reduce this rate.

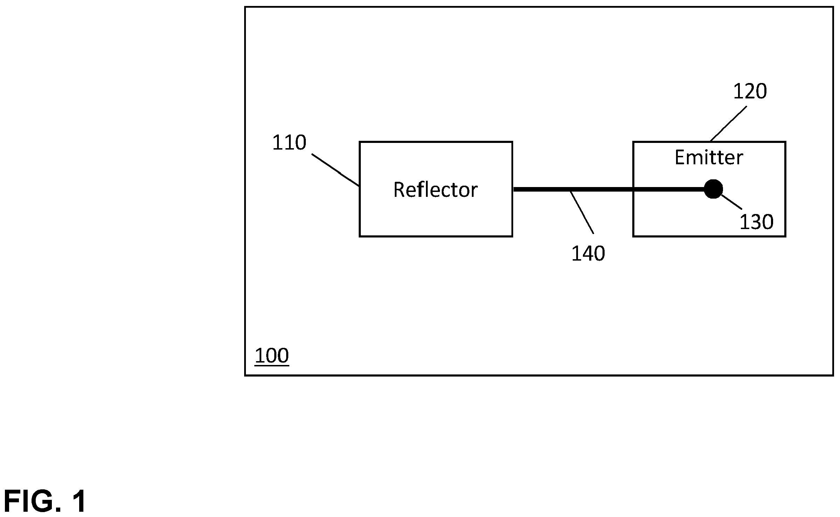

The controlling of a spontaneous emission of a quantum emitter is performed, for example, by an apparatus as depicted in Fig. 1. Controlling of spontaneous emissions may include a suppression of said emissions and/or a constraining of said emissions to a specific direction.

An apparatus 100 for suppressing spontaneous emissions of two or more quantum emitters 130 comprises two or more quantum emitters 130, which are located in a plane. Such a quantum emitter may be, for example, an ion, an atom, a quantum dot, or any other type of quantum (information) entity.

In an exemplary implementation, the quantum entities may be ions included in a trap, as explained in section *Ion traps.*

The quantum emitters are located in a plane. For example, the quantum emitters may be arranged in an array, such as a grid or a linear chain, or the like.

Moreover, the apparatus 100 includes a reflector 110. The reflector is located along an axis perpendicular to the plane. The reflector 110 is adapted to reflect an emission 140 of a quantum emitter 120 out of the two or more quantum emitters 130 according to a boundary condition. The boundary condition includes obtaining destructive interference of the reflected emissions with the emissions of the two or more quantum emitters 130.

In other words, the reflector 110 may be adapted to invert the wave fronts of the radiation generated by spontaneous emission in the far-field of the emitters so that the returning radiation interferes destructively with the primary emitted radiation.

The reflector 110 may be adapted to reflect emissions of the at least two quantum emitters out of the two or more emitters simultaneously. In other words, the reflector 110 may be adapted to wave fronts of the radiation generated by spontaneous emissions of two or more quantum emitters simultaneously.

The distance of the reflecting surface and the emitter is selected such that the emitted and the reflected radiation may destructively interfere. Typical photon wave-packet sizes are at the order of meter(s) and hence the distance between the emitter and the reflector should be substantially smaller. In other words, the roundtrip time of the radiation to and from the reflector may be smaller or comparable to the typical coherence time of the spontaneous emission by the quantum entities. The roundtrip time may be controlled by adjusting the distance $R$ between the quantum entities and the reflector. Such temporal interference of an emission and the reflected emission may be achieved for distances $R$ that fulfill the condition

$$\frac{2R}{c} \ll \frac{1}{\Gamma},$$

where $c$ is the speed of light and $\Gamma$ is the free-space decay rate of the observed transition.

The destructive interference between the emitted primary radiation and the reflected radiation suppresses the process of spontaneous emission; both in the direction of the spatial light modulator, as well as on the opposite side. Given the point symmetry of the spontaneous emission, it is possible to fully control the emission rate by covering half of the solid angle.

For example, the reflector 110 may include one or more of a mirror and a spatial light modulator (SLM). In other words, the reflector 110 may include a mirror, a SLM or a combination thereof. Any of said types of reflectors may be adapted to reflect emissions of the at least two quantum emitters out of the two or more emitters simultaneously.

For example, the reflector may include an array of micro-mirrors.

An SLM may include of an array of pixels. Each pixel may be individually controlled to change the amplitude and/or phase of a light wave that is transmitted through or reflected by a respective pixel. Since the spatial emission pattern of an array of quantum emitters is non-trivial it may be advantageous to use an adaptive device (such as an SLM) to control the destructive interference.

For example, a reflective SLM that modulates the reflected light phases may be used. For example, light phases may be adjusted while passing through liquid crystals.

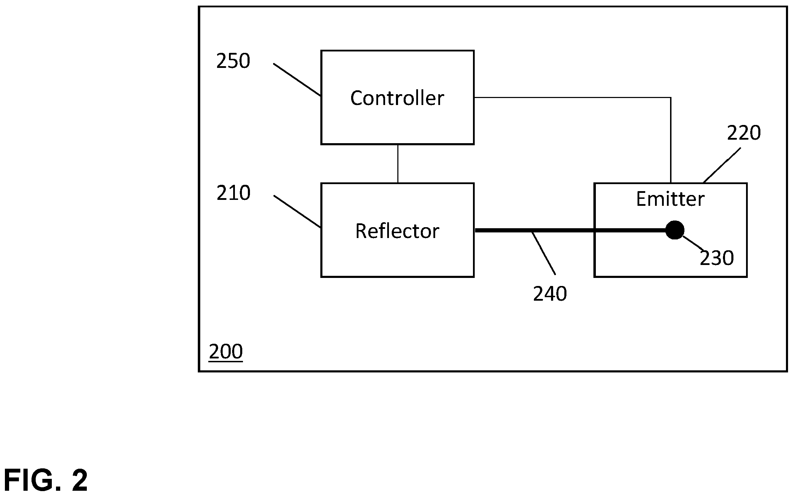

The apparatus 100 may further include a controller. Such an exemplary implementation is performed, for example, by an apparatus as depicted in Fig. 2. The apparatus 200 includes a reflector 210, two or more quantum emitters 220 and a controller 250. The controller may be configured to control a position of the reflector 210. Moreover, the controller 250 may be configured to control a position of an emitter 230 out of the two or more emitters 220. In other words, the position of the reflector 210 as well as the position of the two or more emitters 220 may be adjusted separately. The positions of the reflector 210 as well as the position of the two or more emitters 220 may be selected based on the boundary condition. The position of the reflector 210 as well as the position of the two or more emitters 220 may be adjusted such that an emission 240 of a quantum emitter 230 is reflected onto the position of said quantum emitter 230.

For example, the positions of the reflector, the emitters or any other entity included in the apparatus may be set independently using xyz-nanopositioners. Such positioners may have a step size of 1 nm in each direction, a position readout resolution of 1 nm and a maximum displacement of 12 mm. The reflector may be controlled in position with respect to the ion with a precision of about 10 nm.

Alternatively or in addition, the controller 250 may be configured to control a reflection property of the reflector 210. The reflection property may include phase of the reflected emission. The reflection property may be controlled based on the boundary condition. In other words, the reflection property may be controlled to obtain destructive interference of the reflected emissions with the emissions of the two or more quantum emitters 220.

If the reflector includes a SLM, each of the pixels of said SLM may be controlled individually to adjust the phase of reflected emissions to obtain destructive interference. By individually changing the phase of the light that is reflected by each single pixel, the wave front of the reflected light may be adjusted in such a way, that it destructively interferes with the emission pattern of the quantum emitter that may be included in an array. Since each pixel may be programmed individually, the reflection pattern may be optimized to match the emission pattern of the quantum emitter array, where the specific emission pattern depends on specific parameters of the emitter array, such as the location of emitters, which emitters a being excited, or the like.

Similarly, for an array of micro arrays, each mirror may be controlled individually to adjust the phase of reflected emissions to obtain destructive interference.

In other words, by controlling each pixel and/or each micro-mirror individually, a reflection pattern for the two or more quantum emitters may be obtained, which may obtain destructive interference with spontaneous emissions of the quantum emitters. Such pattern may obtain destructive interference for two or more simultaneous emissions.

The apparatus 100 may further include means for guiding the emission of the quantum emitter onto the reflector. Such means for guiding may be located along the axis perpendicular to the plane.

If the means for guiding the emission are adapted to transmit the emission, the means for guiding (e.g. one or more lenses) may be positioned between the reflector 110 and the two or more quantum emitters 120. For example, the apparatus may include a lens as means for guiding the emission of the quantum emitter, the lens being arranged between the two or more quantum emitters and the reflector. In this example, the two or more quantum emitters may be located in a focal plane of said lens. In other words, the plane, in which the two or more quantum emitters are located, may include a focal point of the guiding means.

If the means for guiding the emission are adapted to reflect the emission, the two or more quantum emitters 120 may be positioned between the means for guiding (e.g. a mirror) and the reflector 110. For example, the apparatus may include a concave mirror as means for guiding the emission of the quantum emitter.

In case when the apparatus includes means for guiding the emission, the reflector may be a flat reflector such as a flat SLM.

For example, the SLM may be one of a phase spatial light modulator or a micro mirror array. As mentioned above, the controller 250 may control for each pixel of the SLM a phase of a reflected emission. Based on the boundary condition, the pixels may be controlled to obtain destructive interference of the emission and the reflected emission.

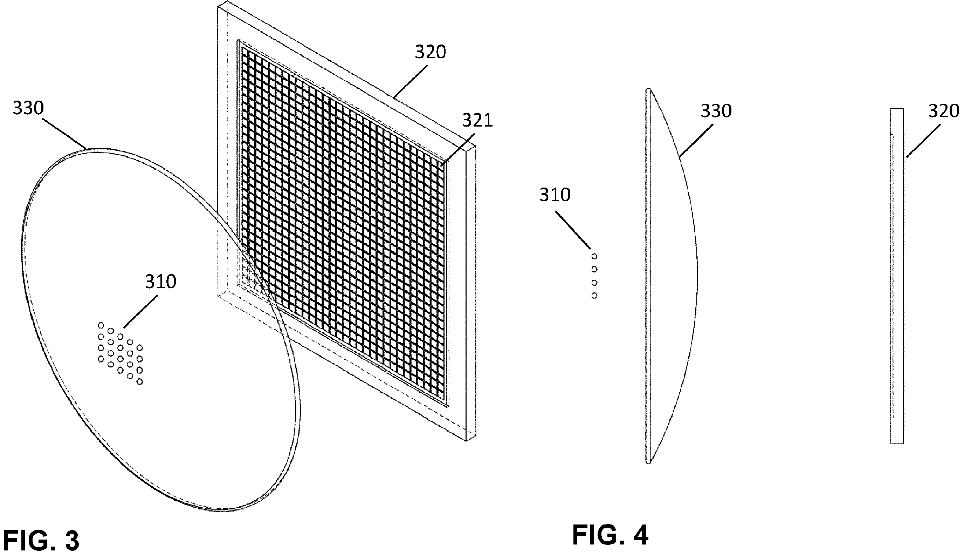

An example is illustrated in **Figs. 3 and 4,** which provide to different views of a first exemplary implementation, which includes a spatial light modulator 320 and a lens 330 to suppress spontaneous emissions of the quantum entities within the array 310.

Fig. 3 provides an angled view of the first exemplary implementation. Fig. 4 provides an angled view of the first exemplary implementation.

The spatial light modulator 320 includes a plurality of pixels 321, which may be arranged in an $M \times N$ array of pixels, where M and N are positive integers.

In the first exemplary implementation, the apparatus may include a lens 330, a phase spatial light modulator 320 and a quantum register including quantum entities that may be arranged, for example, in a planar crystal 310. The entities are located in the focal plane of the lens 330 and their spontaneously emitted radiation is collimated by the lens 330 onto the spatial light modulator 320. The exemplary modulator 320 reflects the emissions back towards the emitters and reshapes the wave fronts of the reflected light according to the phase function programmed on its pixels. In the first exemplary implementation, the phase function is such that the radiation spontaneously emitted by the entities interferes destructively with the radiation returning from the spatial light modulator.

The roundtrip time of the radiation to and from the modulator is, for example, smaller or comparable to the typical coherence time of the spontaneous emission by the quantum entities 310. The roundtrip time may be controlled by adjusting the distance between the entities 310 and the spatial light modulator.

Such destructive interference between the emitted primary radiation and the returning radiation suppresses the process of spontaneous emission; both in the direction of the spatial light modulator, as well as on the opposite side.

In a second exemplary implementation, the reflector may have a hemispherical shape. As already mentioned above, a position of the hemispherical reflector and/or a position of a quantum emitter out of the two or more quantum emitters are adjusted such that a focal point of the hemispherical reflector is located at an intersection of the axis and the plane.

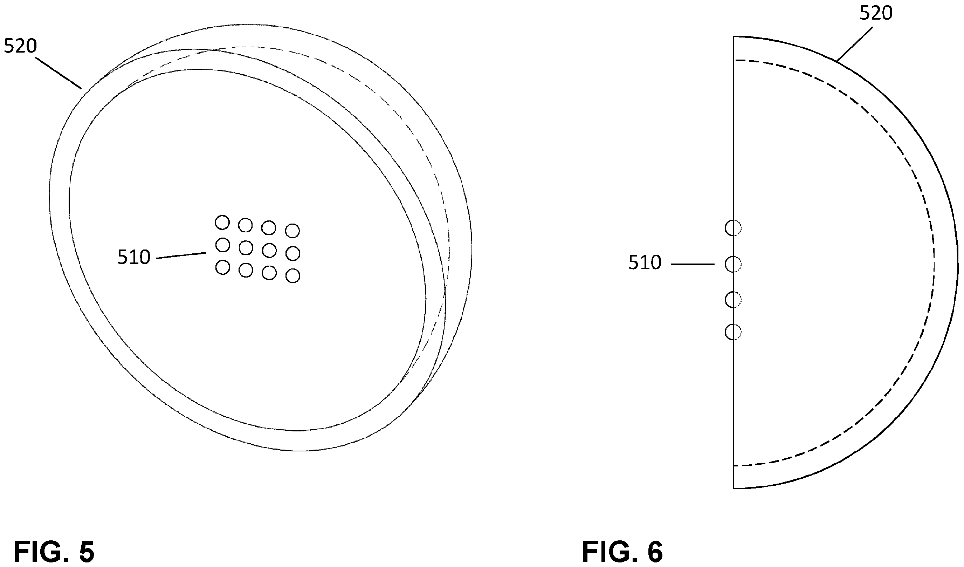

**Figs. 5 and 6** show an exemplary illustration of such a hemispherical reflector. Fig. 5 provides an angled view of the second exemplary implementation. Fig. 6 provides a side view of the second exemplary implementation. The second exemplary implementation includes an array of quantum emitters 510. Moreover, Figs. 5 and 6 illustrate the hemispherical mirror 520.

For example, such a hemispherical reflector may include a plurality of pixels of an SLM that are arranged in a hemisphere. For example, such a hemispherical reflector may include a plurality of micro-mirrors that are arranged in a hemisphere. Each of said pixels or micro-mirrors may be controlled individually to generate a suitable reflection pattern as explained above.

It is noted that although implementations and examples of the present disclosure were provided above in terms of an apparatus for suppressing spontaneous emissions, the corresponding method providing the functionality described by the apparatus are also provided.

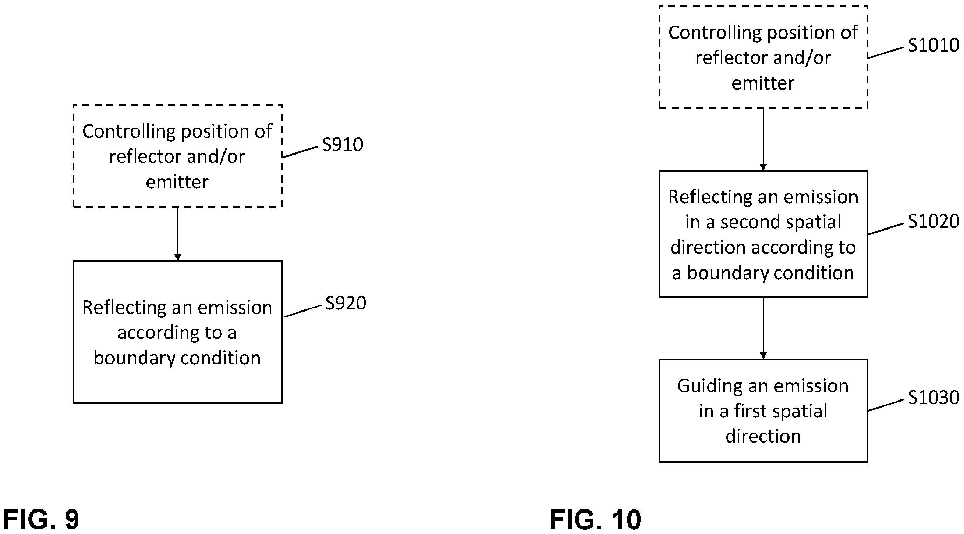

As shown in **Fig. 9,** the method comprises the steps of reflecting S920, by a reflector an emission of an quantum emitter out of the two or more quantum emitters according to a boundary condition, wherein the two or more emitters are located in a plane, the reflector is located along an axis perpendicular to the plane, and the boundary condition includes obtaining destructive interference of the reflected emissions with the emissions of the two or more quantum emitters.

Moreover, as shown in Fig. 9, the method may include the controlling S910 of the position of the reflector and/or the emitter. However, the method is not limited to such a controlling. In general, the method may provide the functionality as described above for the apparatus.

*Constraining of spontaneous emissions*

As mentioned above, for example, for quantum operations, an enhancing of the lifetime of an excited state of a quantum entity and/or reducing the rate of scattered photons at the respective transition is desired. In addition, it may be advantageous to constrain spontaneous emissions to a selected direction.

The constraining (i.e. guiding) of a spontaneous emission of a quantum emitter is performed, for example, by an apparatus as depicted in Fig. 1. Such an apparatus may reflect the radiation in specific directions of emission for selective control.

Such constraining may increase the fidelity of an operation (e.g. an ion-photon entanglement). For example, in the desired direction a device (such as a detector) that measures the emitted photons may be located. Without such constraining, every photon that is not detected (i.e. emitted in a direction where the detector is not) reduces the fidelity of a desired operation.

An apparatus 100 for guiding spontaneous emissions of a quantum emitter 120 in a first spatial direction comprises the quantum emitter 120. Such a quantum emitter may be, for example, an ion, an atom, a quantum dot, or any other type of quantum (information) entity.

In an exemplary implementation, the quantum emitter may be included in an array of two or more quantum emitters. Such array may be, for example, ions included in a trap, as explained in section *Ion traps.* Such two or more quantum emitters may be located in a plane. For example, the quantum emitters may be arranged in an array, such as a grid or a linear chain, or the like.

Moreover, the apparatus 100 includes a reflector 110. The reflector 110 is adapted to reflect an emission 140 of a quantum emitter 130 in a second spatial direction according to a boundary condition. The second spatial direction may be different from the first spatial direction. The boundary condition includes obtaining destructive interference of the reflected emissions with the emissions of said quantum emitter 120.

The destructive interference is obtained analogously as explained above in section *Suppression of spontaneous emissions.*

For the guiding spontaneous emissions in a first spatial direction, the reflector 110 includes a portion adapted to guide an emission in said first spatial direction. In other words, spontaneous emissions of the quantum emitter are allowed in the first direction. Moreover, due to point symmetry, spontaneous emissions of the quantum emitter are allowed in the opposite of the first direction. Spontaneous emissions are suppressed in the second spatial direction. In said second spatial direction, the reflector reflects the spontaneous emissions according to the boundary condition by obtaining destructive interference. By such a configuration spontaneous emissions are constrained to the first spatial direction. Such constraining includes a suppression in a second spatial direction.

The guiding of the emission in the first spatial direction may include not obtaining a destructive interference with the emission of the quantum emitter in the first spatial direction. Moreover, destructive interference is neither obtained in the opposite direction of said first direction.

The apparatus 100 may further include a controller. Such an exemplary implementation is performed, for example, by an apparatus as depicted in Fig. 2. The apparatus 200 includes a reflector 210, a quantum emitter 230 and a controller 250. The controller may be configured to control a position of the reflector 210. Moreover, the controller 250 may be configured to control a position of the emitter 230. In other words, the position of the reflector 210 as well as the position of the emitter 230 may be adjusted separately. The positions of the reflector 210 as well as the position of the emitters 230 may be selected based on the boundary condition. The positions of the reflector 210 as well as the position of the emitter 230 may be adjusted such that an emission 240 of the quantum emitter 230 is reflected onto the position of said quantum emitter 230.

For example, the positions of the reflector, the emitters or any other entity included in the apparatus may be set independently using xyz-nanopositioners. Such positioners may have a step size of 1 nm in each direction, a position readout resolution of 1 nm and a maximum displacement of 12 mm. The reflector may be controlled in position with respect to the ion with a precision of about 10 nm.

As mentioned in section *Suppression of Spontaneous Emissions,* the distance of the reflecting surface and the emitter is selected such that the emitted and the reflected radiation may destructively interfere. The roundtrip time may be controlled by adjusting the distance *R* between the quantum entities and the reflector. Such temporal interference of an emission and the reflected emission may be achieved for distances *R* that fulfill the condition

$$\frac{2R}{c} \ll \frac{1}{\Gamma},$$

where *c* is the speed of light and $\Gamma$ is the free-space decay rate of the observed transition.

For example, in the case of a single emitter located in the center of curvature of the reflector, such as, for example, a hemispherical mirror, destructive interference is obtained for $R = n\lambda/2$, where *n* is a positive integer and $\lambda$ is the wavelength of the transition.

The controller may be further configured to control a focal length of the reflector, and thus the radius of curvature of the reflector.

In case the reflector is a mirror, the controller may be further configured to control a focal length of the reflector, and thus the radius of curvature of the reflector.

The radius of curvature of the mirror may be controlled via temperature based on a uniform thermal expansion of the substrate. For example, for Aluminum the temperature may be controlled with the precision of 10 mK. The temperature may be maintained by radiative heat transfer.

If more than one wavelength should be suppressed at the same time, a suitable temperature may be selected. For example for a Barium ion, a suppression on both the 493nm emission and the 650nm emission may achieved within 2K of temperature tuning.

The reflector may include one or more of a mirror and a spatial light modulator, SLM. Such an exemplary mirror may be adapted to reflect the emission of the quantum emitter in the second spatial direction according to the boundary condition. Such a mirror may be, for example, a hemispherical mirror. However, the present invention is not limited to such a shape of the mirror. Any other suitable shape may be used.

Such an exemplary SLM may be adapted to reflect the emission of the quantum emitter in the second spatial direction according to the boundary condition.

The portion for guiding an emission of the quantum emitter in a first spatial direction may include an opening in said first spatial direction. Such an opening may include a slit, a hole (e.g., a circular hole) or the like. For example, the mirror includes an opening in a first direction. In said first direction, there is no destructive interference of an emission in said direction as well as in the opposite direction.

The portion for guiding an emission of the quantum emitter in a first spatial direction may include an optical device for guiding said emission in the first spatial direction. For example, the portion may include a lens, an optical fiber, or a combination thereof. For example, the portion may include a spatial light modulator (SLM), which is explained in detail in section *Suppression of spontaneous emissions,* for shaping the emission in the first spatial direction. However, the present invention is not limited to the above-mentioned exemplary optical devices.

In a third exemplary implementation, the reflector may be a hemispherical mirror. A position of the hemispherical mirror and/or a position of the quantum emitter may be adjusted such that the quantum emitter is located at a focal point of the hemispherical mirror.

The adjustment of the position of the mirror may be performed independently of the adjustment of the position of the emitter. The adjustment may be performed using the controller as explained above.

If the quantum emitter is included in a planar array of two or more quantum emitters, the focal point of the hemispherical mirror may be located at an intersection of the axis and the plane of the array.

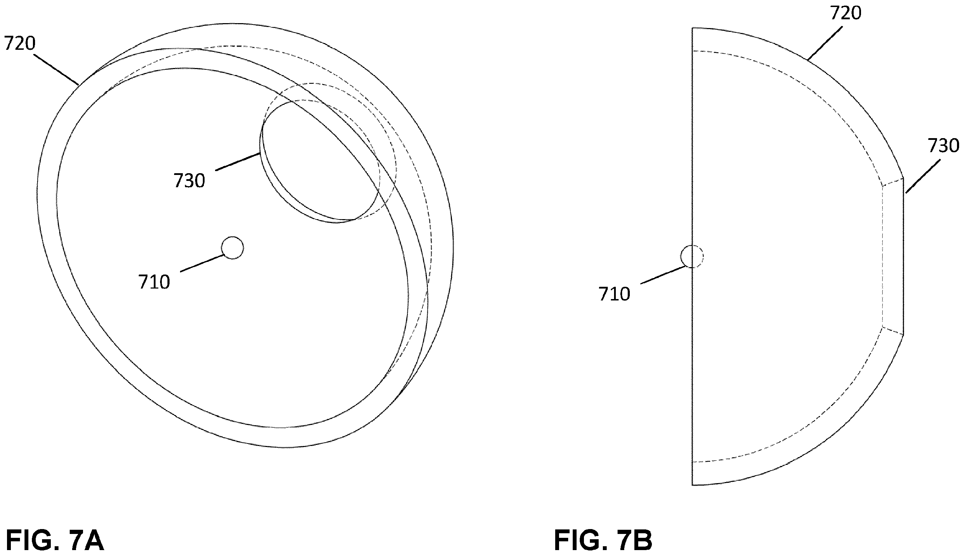

**Figs. 7A to 7C** exemplarily illustrate the third exemplary implementation in which a quantum information entity 710 is located in the center of curvature of a hollow hemispherical mirror 720.

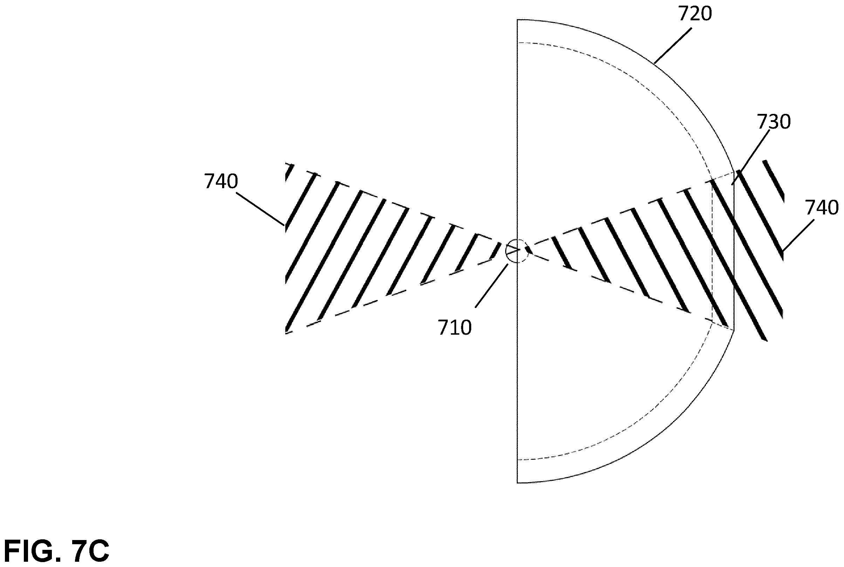

Fig. 7A provides an angled view of the third exemplary implementation. Fig. 7B provides a side view of the third exemplary implementation. Fig. 7C illustrates selected regions for the guiding of spontaneous emissions.

Spontaneous emissions may be suppressed along the directions in which reflection takes place. In other words, the emission towards the reflective surface and towards the opposite side may be suppressed. The emission directions towards the circular hole 730 and towards the opposite side, which are illustrated as dashed regions 740 in Fig. 7C, are allowed. In other words, there is no destructive interference for emissions into the direction of the circular hole 730 and into the opposite direction. The position and number of regions of selective emission control may be chosen arbitrarily.

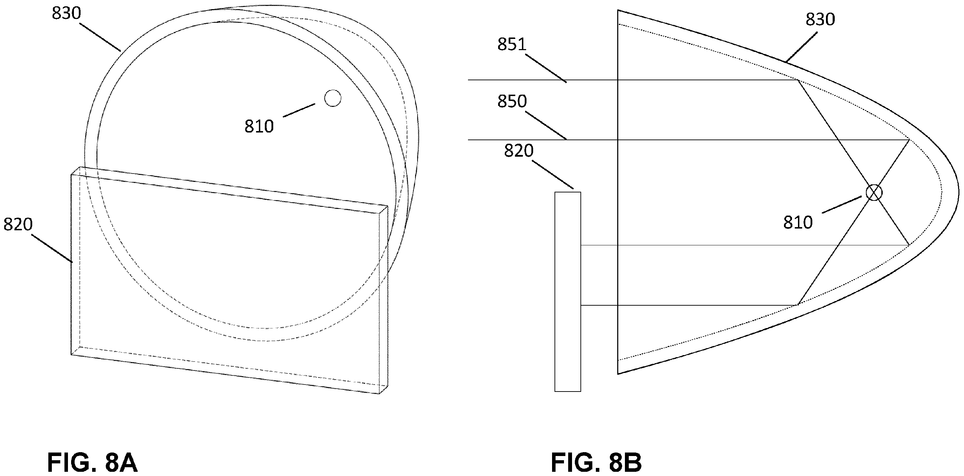

**Figs. 8A to 8C** exemplarily illustrate the fourth exemplary implementation in which a quantum information entity 810 is located in the focal point of a hollow parabolic mirror 830. Fig. 8A provides an angled view of the fourth exemplary implementation. Fig. 8B provides a side view of the fourth exemplary implementation. Fig. 8B provides exemplary optical rays 850, 851 for an emission of the quantum emitter 810.

In a first example of the fourth exemplary implementation, the reflector 820 may be a SLM. The parabolic mirror 830 may be adapted to guide an emission onto the SLM 820. A position of the parabolic mirror 830 and/or a position of the quantum emitter 810 are adjusted such that the quantum emitter 810 is located at a focal point within the parabolic mirror 830. The adjustment of the position of the mirror may be performed independently of the adjustment of the position of the emitter. The adjustment may be performed using the controller as explained above.

Moreover, the SLM may guide an emission of the quantum emitter into the first spatial direction and to reflect an emission into a second spatial direction according to the boundary condition. In other words, the pixels of the SLM may be controlled to obtain destructive interference for an emission in a second direction. In addition, the SLM may be controlled to not obtain destructive interference in a first direction. For example, the SLM may be controlled to obtain constructive interference in said first direction. Thus, an emission is guided into a first direction and an emission is suppressed into a second direction, which may be different from the first direction.

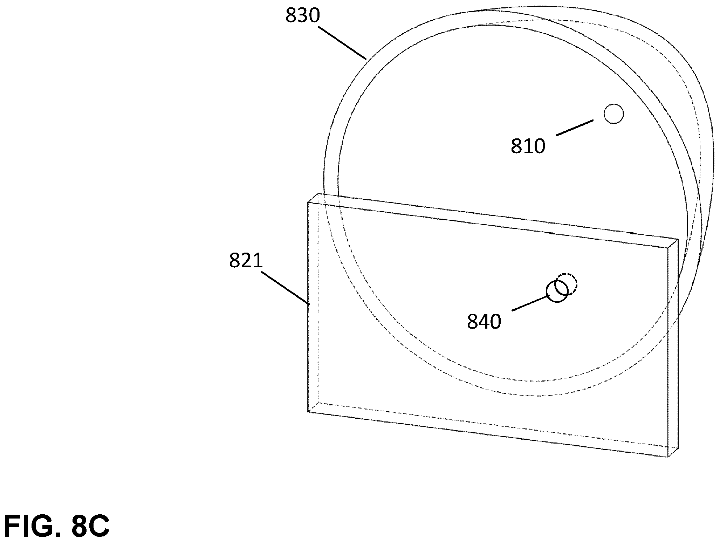

In a second example of the fourth exemplary implementation, which is exemplarily shown in Fig. 8C, the reflector may be a flat mirror 821. The parabolic mirror 830 may be adapted to guide an emission onto the flat mirror 821. A position of the parabolic mirror 830 and/or a position of the quantum emitter 810 may be adjusted such that the quantum emitter 810 is located at a focal point within the parabolic mirror 830. The adjustment of the position of the mirror may be performed independently of the adjustment of the position of the emitter. The adjustment may be performed using the controller as explained above.

The flat mirror 821 may include the portion for guiding an emission into the first spatial direction. Moreover, the flat mirror may reflect an emission into a second spatial direction according to the boundary condition. In other words, the flat mirror is located such that destructive interference is obtained for emissions that are directed onto the flat mirror by the parabolic mirror. The flat mirror may include a portion 840, such as an opening or the like, in a first spatial direction. In said first spatial direction no destructive interference is obtained.

As mentioned above, the quantum emitter may be included in an array of quantum emitters. An emitter may be positioned in the focal point, for example, by moving the emitters in a trap.

It is noted that although implementations and examples of the present disclosure were provided above in terms of an apparatus for guiding spontaneous emissions, the corresponding method for guiding spontaneous emissions of a quantum emitter in a first spatial direction providing the functionality described by the apparatus are also provided.

As shown in **Fig. 10,** the method comprises the steps of reflecting S1020, by a reflector, an emission of the quantum emitter in a second spatial direction according to a boundary condition, wherein the boundary condition includes obtaining destructive interference of the reflected emission with said emission of the quantum emitter, and guiding S1030 an emission of the quantum emitter in the first spatial direction.

Moreover, as shown in Fig. 10, the method may include the controlling S1010 of the position of the reflector and/or the emitter. However, the method is not limited to such a controlling. In general, the method may provide the functionality as described above for the apparatus.

*Implementations in software and hardware*

It is noted that any of the steps of the method described above may be included as code instructions in a program, which may be executed by one or more processors.

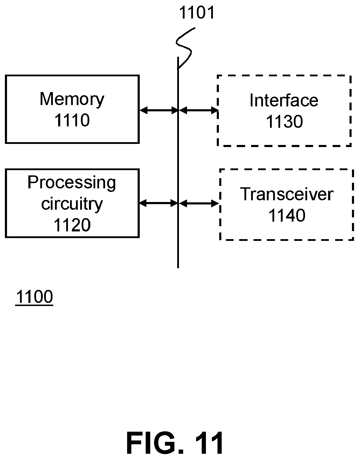

**Fig. 11** shows an exemplary controller 1100, which is included in the apparatus described in the present disclosure. For example, the controller may control the positions of a reflector and/or an emitter and may additionally control further components included in the apparatus for suppressing or guiding an emission. Such a device may include memory 1110, processing circuitry 1120, and possibly a transceiver 1140 and a user interface 1130. The device may be, for instance a (part of) a computing device or any other suitable device.

The memory 1110 may store the program, which may be executed by the processing circuitry 1120 to perform steps of any of the above-mentioned methods. The processing circuitry may comprise one or more processors and/or other dedicated or programmable hardware. The transceiver 1140 may be configured to receive and/or transmit (controlling) signals. The device 1100 may further include a user interface 1130 for displaying messages or status of the device, or the like and/or for receiving a user's input. A bus 1101 interconnects the memory, the processing circuitry, the transceiver, and the user interface.

It is noted that the controller may be implemented by any hardware means, apart from using a general purpose processor, it can be implemented as a microcontroller, by means of a programmable hardware such as field programmable gate array (FPGA) or as a specialized hardware such as an application-specific integrated circuit (ASIC). Any combination of the above-mentioned hardware and possibly a software may be used.

*Further Aspects*

According to an embodiment, an apparatus for guiding spontaneous emissions of a quantum emitter in a first spatial direction is provided. The apparatus comprises the quantum emitter; a reflector adapted to reflect an emission of the quantum emitter in a second spatial direction according to a boundary condition, wherein the boundary condition includes obtaining destructive interference of the reflected emission with said emission of the quantum emitter, and the reflector including a portion adapted to guide an emission of the quantum emitter in a first spatial direction.

In an exemplary implementation, the guiding of the emission in the first spatial direction includes not obtaining a destructive interference with the emission of the quantum emitter in the first spatial direction.

For example, the apparatus further includes a controller adapted to control one or more of a position of the reflector and/or a position of the quantum emitter based on the boundary condition, and a focal length of the reflector.

In an exemplary implementation, the reflector includes one or more of a mirror and a spatial light modulator, SLM.

For example, the portion for guiding an emission of the quantum emitter in a first spatial direction includes an opening in said first spatial direction.

In an exemplary implementation, the portion for guiding an emission of the quantum emitter in the first spatial direction includes an optical device for guiding said emission in the first spatial direction.

For example, the reflector is a hemispherical mirror, and a position of the hemispherical mirror and/or a position of the quantum emitter are adjusted such that the quantum emitter is located at a focal point of the hemispherical mirror.

In an exemplary implementation, the reflector is a SLM, the apparatus further includes a parabolic mirror, the parabolic mirror adapted to guide an emission onto the SLM, a position of the parabolic mirror and/or a position of the quantum emitter are adjusted such that the quantum emitter is located at a focal point within the parabolic mirror, and the SLM is configured to guide an emission of the quantum emitter into the first spatial direction and to reflect an emission of the quantum emitter into a second spatial direction according to the boundary condition.

For example, the reflector is a flat mirror, the apparatus further includes a parabolic mirror, the parabolic mirror adapted to guide an emission onto the flat mirror, a position of the parabolic mirror and/or a position of the quantum emitter are adjusted such that the quantum emitter is located at a focal point within the parabolic mirror, the flat mirror includes the portion for guiding an emission of the quantum emitter into the first spatial direction, the flat mirror is adapted to reflect an emission of the quantum emitter into a second spatial direction according to the boundary condition.

In an exemplary implementation, the apparatus further includes an array of two or more quantum emitters, the array including the quantum emitter.

According to an embodiment, a method for guiding spontaneous emissions of a quantum emitter in a first spatial direction is provided. The method comprises reflecting, by a reflector, an emission of the quantum emitter in a second spatial direction according to a boundary condition, wherein the boundary condition includes obtaining destructive interference of the reflected emission with said emission of the quantum emitter, and guiding an emission of the quantum emitter in the first spatial direction.

Some of the further aspects relate to an apparatus and methods for guiding spontaneous emissions of a quantum emitter in a first spatial direction. A reflector reflects an emission of the quantum emitter in a second spatial direction according to a boundary condition, wherein the boundary condition includes obtaining destructive interference of the reflected emission with said emission of the quantum emitter, and the reflector includes a portion adapted to guide an emission of the quantum emitter in the first spatial direction.

The embodiments and exemplary implementations mentioned above show some non-limiting examples. It is understood that various modifications may be made without departing from the claimed subject matter. For example, modifications may be made to adapt the examples to new systems and scenarios without departing from the central concept described herein.

Summarizing, some embodiments in the present disclosure relate to an apparatus and methods for suppressing spontaneous emissions of two or more quantum emitters. The two or more quantum emitters are located in a plane. A reflector is located along an axis perpendicular to the plane. The reflector reflects an emission of a quantum emitter out of the two or more quantum emitters according to a boundary condition, wherein the boundary condition includes obtaining destructive interference of the reflected emissions with the emissions of the two or more quantum emitters.

**Claims**

1. An apparatus for suppressing spontaneous emissions of two or more quantum emitters comprising

   two or more quantum emitters, which are located in a plane; and
   a reflector located along an axis perpendicular to the plane, the reflector adapted to reflect an emission of a quantum emitter out of the two or more quantum emitters according to a boundary condition, wherein the boundary condition includes obtaining destructive interference of the reflected emissions with the emissions of the two or more quantum emitters.

2. The apparatus according to claim 1, wherein the reflector is adapted to reflect emissions of the at least two quantum emitters out of the two or more emitters simultaneously.

3. The apparatus according to any of claims 1 or 2, wherein the apparatus further includes a controller configured to control one or more of

   - a position of the reflector and/or a position of an emitter out of the two or more emitters, and
   - a reflection property of the reflector including a phase of the reflected emission based on the boundary condition.

4. The apparatus according to any of claims 1 or 2, wherein the reflector includes one or more of a mirror and a spatial light modulator, SLM.

5. The apparatus according to any of claim 4, wherein the SLM is one of a phase spatial light modulator or a micro mirror array, and the controller is configured to control, for each pixel of the SLM, a phase of a reflected emission based on the boundary condition.

6. The apparatus, according to any of claims 1 to 5, wherein the apparatus further includes means for guiding the emission of the quantum emitter onto the reflector, wherein the means for guiding the emission are located along the axis perpendicular to the plane.

7. The apparatus, according to any of claims 5 to 6, wherein the apparatus further includes a lens as means for guiding the emission of the quantum emitter, the lens being arranged between the two or more quantum emitters and the reflector, wherein the two or more quantum emitters are located in a focal plane of said lens.

8. A method for suppressing spontaneous emissions of two or more quantum emitters comprising

   reflecting, by a reflector an emission of an quantum emitter out of the two or more quantum emitters according to a boundary condition,
   wherein the two or more emitters are located in a plane,
   the reflector is located along an axis perpendicular to the plane, and
   the boundary condition includes obtaining destructive interference of the reflected emissions with the emissions of the two or more quantum emitters.

**Amended claims in accordance with Rule 137(2) EPC.**

1. An apparatus (200) for suppressing spontaneous emissions of two or more quantum emitters (220) comprising

   two or more quantum emitters (220), which are located in a plane, wherein a quantum emitter is an ion or an atom;
   a reflector (210) located along an axis perpendicular to the plane, the reflector adapted to reflect an emission of a quantum emitter (230) out of the two or more quantum emitters (220) according to a boundary condition, wherein the boundary condition includes obtaining destructive interference of the reflected emissions with the emissions of the two or more quantum emitters (220); and
   a controller (250) configured to control one or more of

   - a position of the reflector (210) and/or a position of an emitter (230) out of the two or more emitters (220), and
   - a reflection property of the reflector (210) corresponding to a phase of the reflected emission

   based on the boundary condition.

2. The apparatus (200) according to claim 1, wherein the reflector (210) is adapted to reflect emissions of the at least two quantum emitters out of the two or more emitters (220) simultaneously.

3.  The apparatus (200) according to any of claims 1 or 2, wherein the reflector (210) includes one or more of a mirror and a spatial light modulator (320), SLM.

4.  The apparatus (200) according to any of claim 3, wherein the SLM (320) is one of a phase spatial light modulator or a micro mirror array, and
    the controller (250) is configured to control, for each pixel of the SLM (320), a phase of a reflected emission based on the boundary condition.

5.  The apparatus (200), according to any of claims 1 to 4, wherein the apparatus (200) further includes means for guiding the emission of the quantum emitter (230) onto the reflector (210), wherein the means for guiding the emission are located along the axis perpendicular to the plane.

6.  The apparatus (200), according to any of claims 4 to 5, wherein the apparatus (200) further includes a lens (330) as means for guiding the emission of the quantum emitter (230), the lens (330) being arranged between the two or more quantum emitters (220) and the reflector (210), wherein the two or more quantum emitters (220) are located in a focal plane of said lens (330).

7.  A method for suppressing spontaneous emissions of two or more quantum emitters (220) comprising

    controlling (S910) by a controller (250) one or more of

    - a position of a reflector (210) and/or a position of an emitter (230) out of the two or more emitters (220), and
    - a reflection property of the reflector (210) corresponding to a phase of the reflected emission

    based on the boundary condition,
    reflecting (S920), by the reflector (210) an emission of an quantum emitter (230) out of the two or more quantum emitters (220) according to a boundary condition,
    wherein a quantum emitter is an ion or an atom,
    the two or more emitters (220) are located in a plane,
    the reflector (210) is located along an axis perpendicular to the plane, and
    the boundary condition includes obtaining destructive interference of the reflected emissions with the emissions of the two or more quantum emitters (220).

**FIG. 1**

**FIG. 2**

**FIG. 3**

**FIG. 4**

520

510

**FIG. 6**

520

510

**FIG. 5**

FIG. 7B

FIG. 7A

FIG. 7C

**FIG. 8A**

**FIG. 8B**

EP 4 459 370 A1

FIG. 8C

EP 4 459 370 A1

```
┌ ─ ─ ─ ─ ─ ─ ─ ─ ─ ┐
│ Controlling position of │        S910
│   reflector and/or     ├──────
│       emitter          │
└ ─ ─ ─ ─ ─ ─ ─ ─ ─ ┘
            │
            ▼
┌───────────────────┐
│                   │
│ Reflecting an emission │        S920
│   according to a      ├──────
│  boundary condition   │
│                   │
└───────────────────┘
```

**FIG. 9**

```
┌ ─ ─ ─ ─ ─ ─ ─ ─ ─ ┐
│ Controlling position of │        S1010
│   reflector and/or     ├──────
│       emitter          │
└ ─ ─ ─ ─ ─ ─ ─ ─ ─ ┘
            │
            ▼
┌───────────────────┐
│ Reflecting an emission │
│  in a second spatial   │        S1020
│ direction according to ├──────
│  a boundary condition  │
└───────────────────┘
            │
            ▼
┌───────────────────┐
│ Guiding an emission    │
│   in a first spatial   │        S1030
│       direction        ├──────
└───────────────────┘
```

**FIG. 10**

Memory
1110

Processing
circuitry
1120

Interface
1130

Transceiver
1140

1101

1100

**FIG. 11**

Europäisches
Patentamt

European
Patent Office

Office européen
des brevets

**EUROPEAN SEARCH REPORT**

Application Number

EP 23 17 1087

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | SU\'AREZ-FORERO D G ET AL: "Quantum hydrodynamics of a single particle", ARXIV.ORG, CORNELL UNIVERSITY LIBRARY, 201 OLIN LIBRARY CORNELL UNIVERSITY ITHACA, NY 14853, 9 August 2019 (2019-08-09), XP081612792, * page 6, line 13 - line 17 * * abstract * | 1-8 | INV. G02F1/21 G02B26/08 G02B6/12 |
| Y | US 2003/053201 A1 (KWEON GYEONG-IL [KR] ET AL) 20 March 2003 (2003-03-20) * paragraph [0092] - paragraph [0093] * * paragraph [0097] * * paragraph [0114] - paragraph [0116] * * figure 7 * | 1-8 | |
| A | ALEXANDER N PODDUBNY: "Driven anti-Bragg subradiant states in waveguide quantum electrodynamics", ARXIV.ORG, CORNELL UNIVERSITY LIBRARY, 201 OLIN LIBRARY CORNELL UNIVERSITY ITHACA, NY 14853, 21 February 2022 (2022-02-21), XP091162298, * figure 1 * * abstract * | 1,8 | |
| | | | TECHNICAL FIELDS SEARCHED (IPC) |
| | | | G02F G02B H01S |
| A | US 2016/147019 A1 (CHEN SHU-LU [TW] ET AL) 26 May 2016 (2016-05-26) * paragraph [0057] * * paragraph [0065] * * paragraph [0070] * * paragraph [0073] * * figure 3D * | 1,8 | |
| A | US 2013/256504 A1 (STEVENSON RICHARD MARK [GB] ET AL) 3 October 2013 (2013-10-03) * paragraph [0050] - paragraph [0051] * | 1,8 | |

-/--

The present search report has been drawn up for all claims

| Place of search | Date of completion of the search | Examiner |
|---|---|---|
| The Hague | 27 September 2023 | Votini, Stefano |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 1 of 3

## EUROPEAN SEARCH REPORT

Application Number

EP 23 17 1087

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SLAMA S ET AL: "Multiple Reflections and Diffuse Scattering in Bragg Scattering at Optical Lattices", ARXIV.ORG, CORNELL UNIVERSITY LIBRARY, 201 OLIN LIBRARY CORNELL UNIVERSITY ITHACA, NY 14853, 29 November 2005 (2005-11-29), XP080214315, DOI: 10.1103/PHYSREVA.73.023424 * abstract * * Section C; page 6 * | 1,8 | |
| A | US 6 608 847 B2 (NEW FOCUS INC [US]) 19 August 2003 (2003-08-19) * figures 1-2 * * paragraph [0033] - paragraph [0034] * | 1,8 | |
| A | ARANEDA G ET AL: "The Panopticon device: An integrated Paul-trap-hemispherical mirror system for quantum optics", REVIEW OF SCIENTIFIC INSTRUMENTS, AMERICAN INSTITUTE OF PHYSICS, 2 HUNTINGTON QUADRANGLE, MELVILLE, NY 11747, vol. 91, no. 11, 11 November 2020 (2020-11-11), XP012251495, ISSN: 0034-6748, DOI: 10.1063/5.0020661 [retrieved on 2020-11-11] * INTRODUCTION AND MOTIVATION; pages 113201-1 * * abstract * | 1,8 | TECHNICAL FIELDS SEARCHED (IPC) |

-/--

The present search report has been drawn up for all claims

| Place of search | Date of completion of the search | Examiner |
|---|---|---|
| The Hague | 27 September 2023 | Votini, Stefano |

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ABRAM I ET AL: "Spontaneous Emission Control in Semiconductor Microcavities with Metallic or Bragg Mirrors", IEEE JOURNAL OF QUANTUM ELECTRONICS, IEEE, USA, vol. 34, no. 1, 1 January 1998 (1998-01-01), XP011051819, ISSN: 0018-9197 * abstract * ----- | 1,8 | |

TECHNICAL FIELDS
SEARCHED (IPC)

The present search report has been drawn up for all claims

| Place of search | Date of completion of the search | Examiner |
|---|---|---|
| The Hague | 27 September 2023 | Votini, Stefano |

EPO FORM 1503 03.82 (P04C01)

## ANNEX TO THE EUROPEAN SEARCH REPORT
## ON EUROPEAN PATENT APPLICATION NO.

EP 23 17 1087

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2023

| Patent document cited in search report | | | Publication date | Patent family member(s) | | | Publication date |
|---|---|---|---|---|---|---|---|
| US 2003053201 | A1 | | 20-03-2003 | CN | 1435017 | A | 06-08-2003 |
| | | | | FR | 2829629 | A1 | 14-03-2003 |
| | | | | GB | 2383911 | A | 09-07-2003 |
| | | | | JP | 2003152254 | A | 23-05-2003 |
| | | | | KR | 100349007 | B1 | 17-08-2002 |
| | | | | US | 2003053201 | A1 | 20-03-2003 |
| | | | | WO | 03024003 | A1 | 20-03-2003 |
| US 2016147019 | A1 | | 26-05-2016 | CA | 2867951 | A1 | 25-04-2015 |
| | | | | CN | 104570203 | A | 29-04-2015 |
| | | | | CN | 110275247 | A | 24-09-2019 |
| | | | | EP | 2866067 | A1 | 29-04-2015 |
| | | | | JP | 6640445 | B2 | 05-02-2020 |
| | | | | JP | 2015111255 | A | 18-06-2015 |
| | | | | KR | 20150048078 | A | 06-05-2015 |
| | | | | SG | 10201406933Y | A | 28-05-2015 |
| | | | | TW | 201530206 | A | 01-08-2015 |
| | | | | US | 2015117808 | A1 | 30-04-2015 |
| | | | | US | 2016147019 | A1 | 26-05-2016 |
| US 2013256504 | A1 | | 03-10-2013 | GB | 2502509 | A | 04-12-2013 |
| | | | | JP | 5694407 | B2 | 01-04-2015 |
| | | | | JP | 2013214051 | A | 17-10-2013 |
| | | | | US | 2013256504 | A1 | 03-10-2013 |
| US 6608847 | B2 | | 19-08-2003 | NONE | | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **H. HÄFFNER, ; C.F. ROOS, ; R. BLATT,.** Quantum computing with trapped ions. *Physics Reports,* 2008, vol. 469 (4), 155-203, https://doi.org/10.1016/j.phys-rep.2008.09.003

- **G. CHEN et al.** Quantum Computing Devices: Principles, Designs, and Analysis. CRC Press, 2019